# EUROPEAN PATENT APPLICATION

(11) **EP 2 720 122 A2**
(43) Date of publication of application: **16.04.2014**
(21) Application number: 13160560.2
(22) Date of filing: 22.03.2013
(51) Int. Cl.: G06F 3/041

(54) **Touch sensing system**

(30) Priority: 15.10.2012 KR 20120114222
(71) Applicant: Samsung Display Co., Ltd., Yongin-City, Gyeonggi-Do, 446-711 (KR)
(72) Inventor: Ahn, Soon-Sung, 446-711 Yongin-City (KR); Jang, Hyoung-Wook, 446-711 Yongin-City (KR)
(74) Representative: Gulde Hengelhaupt Ziebig & Schneider

(57) **Abstract**

A touch sensing system (100, 200, 300) includes: a first touch sensor (110, 210, 310); a second touch sensor (120, 220, 320); and a control IC (130, 230, 330) configured to control the first touch sensor (110, 210, 310) and the second touch sensor (120, 220, 320).

## Description

### CROSS-REFERENCE TO RELATED APPLICATION

This application claims priority to and the benefit of Korean Patent Application No. 10-2012-0114222, filed on October 15, 2012, in the Korean Intellectual Property Office.

### BACKGROUND

### 1.Field

Embodiments of the present invention relate to a touch sensing system.

### 2.Description of the Related Art

A touch sensor is a sensor (or a panel of sensors) which recognizes user's hand or contact of an object. Because such a sensor can be used as a substitute for input devices such as keyboards and mice, it has been widely used in various electronic devices.

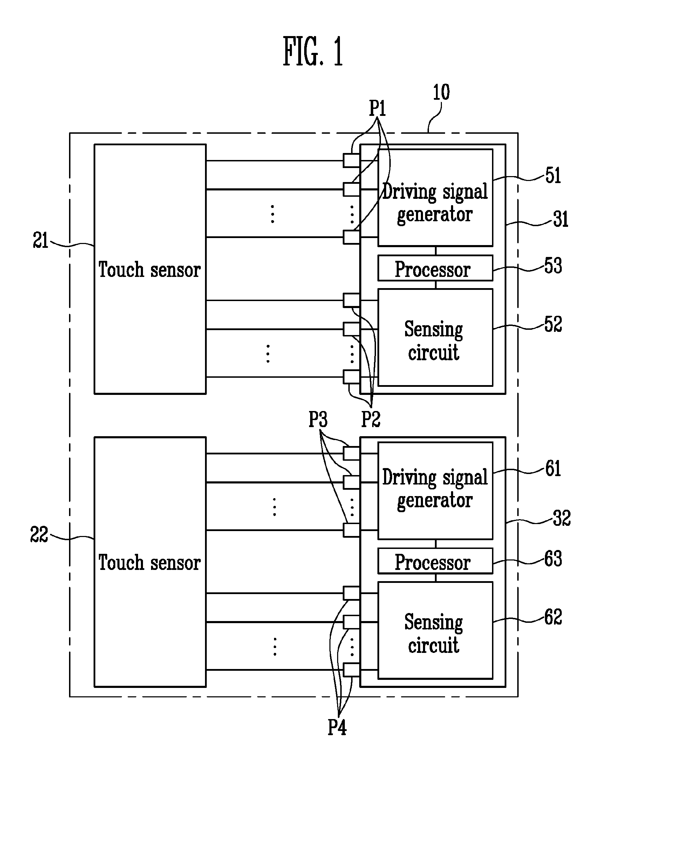

Also, in addition to methods using one touch sensor, methods using a plurality of touch sensors as shown in FIG. 1 have been proposed.

Referring to FIG. 1, a touch sensing system 10 according to the related art includes two touch sensors (or two touch sensor panels) and two control ICs 31 and 32 controlling the two touch sensors 21 and 22.

That is, a first touch sensor 21 may be individually controlled by a first control IC 31 and a second touch sensor 22 may be individually controlled by a second control IC 32.

However, when each of the control ICs is used to control a corresponding one of the plurality of touch sensors, as described above, resources such as a driving signal generator, a sensing circuit, processors or the like are duplicated in the control ICs. Therefore, there are disadvantages of increasing manufacturing cost and the number of pins connecting to the touch sensor.

### SUMMARY

One aspect of embodiments of the present invention is to provide a touch sensing system having a reduced cost, a smaller circuit area, and a reduced number of pins by allowing a plurality of touch sensors to share one control IC with each other.

According to an exemplary embodiment of the present invention, the touch sensing system includes a first touch sensor; a second touch sensor; and a control integrated circuit (IC) configured to control the first touch sensor and the second touch sensor.

The control IC may include a plurality of first pins coupled to both the first touch sensor and the second touch sensor, a plurality of second pins coupled to the first touch sensor, and a plurality of third pins coupled to the second touch sensor.

The control IC may further include a driving signal generator configured to output a driving signal to the first pins.

The control IC may further include a first sensing circuit configured to receive a first plurality of output signals of the first touch sensor through the second pins and a second sensing circuit configured to receive a second plurality of output signals of the second touch sensor through the third pins.

The control IC may further include a processor configured to determine a first touch position of the first touch sensor using the first output signals received by the first sensing circuit and configured to determine a second touch position of the second touch sensor using the second output signals received by the second sensing circuit.

The first touch sensor may be configured to receive the driving signals output from the first pins and may be configured to output the first output signals to the second pins, and the second touch sensor may be configured to receive the driving signals output from the first pins and may be configured to output the second output signals to the third pins.

The control IC may further include a multiplexer (MUX) coupled to both the second pins and the third pins and a sensing circuit coupled to the MUX.

The MUX may be configured to selectively transfer the first output signals of the first touch sensor received through the second pins and the second output signals of the second touch sensor received through the third pins to the sensing circuit.

The MUX may be configured to transfer the first output signals of the first touch sensor received through the second pins to the sensing circuit during a first period and may be configured to transfer the second output signals of the second touch sensor received through the third pins to the sensing circuit during a second period.

The control IC may further include a processor configured to determine a first touch position of the first touch sensor using the first output signals of the first touch sensor transferred to the sensing circuit during the first period and configured to determine a second touch position of the second touch sensor using the second output signals of the second touch sensor transferred to the sensing circuit during the second period.

The first touch sensor may be configured to receive the driving signals output from the first pins and may be configured to output the first output signals to the second pins, and the second touch sensor may be configured to receive the driving signals output from the first pins and may be configured to output the second output signals to the third pins.

The control IC may include a first driving signal generator configured to output a first plurality of driving signals to the second pins and a second driving signal generator configured to output a second plurality of driving signals to the third pins.

The control IC may further include a sensing circuit configured to receive a first plurality of output signals of the first touch sensor and a second plurality of output signals of the second touch sensor received through the first pins.

The control IC may further include a processor configured to determine a plurality of touch positions in the first touch sensor and the second touch sensor using the first output signals and the second output signals transferred to the sensing circuit.

The first touch sensor may be configured to receive the first driving signals from the second pins and may be configured to output the first output signals to the first pins, and the second touch sensor may be configured to receive the second driving signals output from the third pins and may be configured to output the second output signals to the first pins.

The first touch sensor and the second touch sensor may be disposed in a horizontal direction. The first touch sensor and the second touch sensor may be disposed in a vertical direction.

The first touch sensor and the second touch sensor may be the same type of touch sensor or the first touch sensor and the second touch sensor may be different types of touch sensors.

### BRIEF DESCRIPTION OF THE DRAWINGS

The accompanying drawings, together with the specification, illustrate exemplary embodiments of the present invention, and, together with the description, serve to explain the principles of the present invention.

FIG. 1 is a schematic block diagram of a touch sensing system according to the related art.

FIG. 2 is a schematic block diagram of a touch sensing system according to a first embodiment of the present invention.

FIG. 3 is a waveform diagram of an operation of a driving signal generator according to the embodiment shown in FIG. 2.

FIG. 4 is a schematic block diagram of a touch sensing system according to a second embodiment of the present invention.

FIG. 5 is a waveform diagram of an operation of a driving signal generator according to the embodiment shown in FIG. 4.

FIG. 6 is a schematic block diagram of a touch sensing system according to a third embodiment of the present invention.

FIGS. 7 and 8 are views showing arrangements of a first touch sensor and a second touch sensor according to embodiments of the present invention.

### DETAILED DESCRIPTION

Aspects and features of embodiments of a touch sensing system according to the present invention and methods to achieve them will be elucidated from exemplary embodiments described below in detail with reference to the accompanying drawings. However, the present invention is not limited to exemplary embodiments disclosed below, but may be implemented in various different forms. In addition, in the following description, a case in which any part is coupled to another part includes a case in which the parts are directly coupled with each other and a case in which the parts are coupled with each other, having another element interposed therebetween. In the accompanying drawings, portions unrelated to the description will be omitted in order to clearly describe the present invention, and similar reference numerals will be used to describe similar portions throughout the present specification.

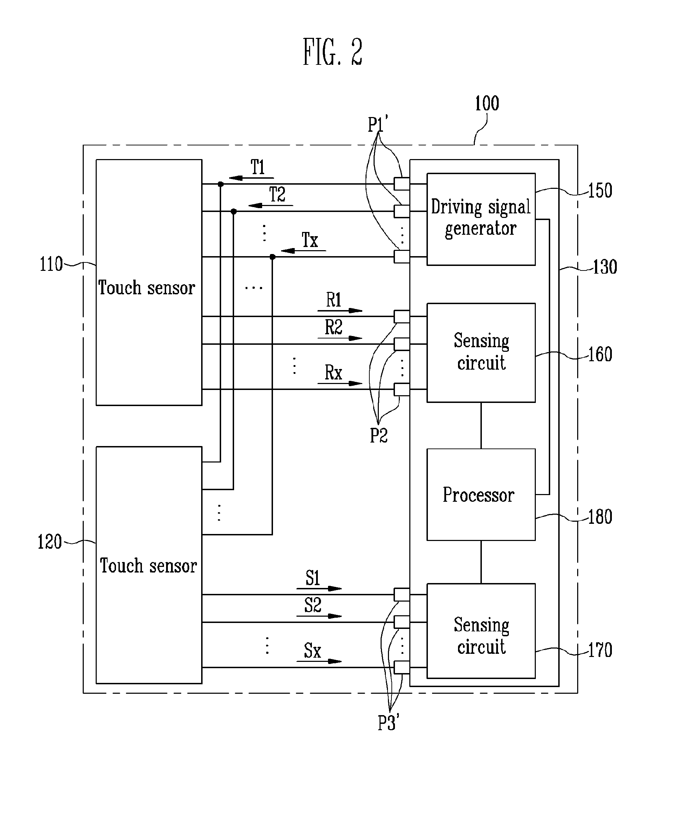

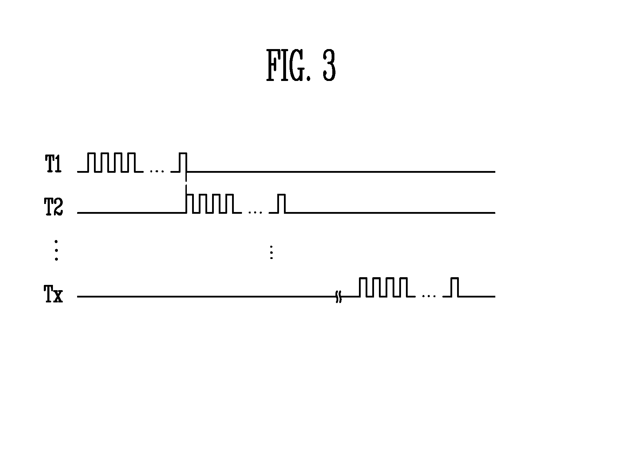

FIG. 2 is a schematic block diagram of a touch sensing system according to a first embodiment of the present invention and FIG. 3 is a waveform diagram of an operation of a driving signal generator, according to the embodiment shown in FIG. 2.

Referring to FIG. 2, the touch sensing system 100 according to the first embodiment of the present invention includes a first touch sensor 110 (e.g., a touch sensor panel or an array of touch sensitive elements arranged in a panel), a second touch sensor 120, and a control IC 130.

The first touch sensor 110 may detect a contact or an approach state of an object to receive a command from the outside.

Here, the first touch sensor 110 may be implemented as any of various suitable types of sensors. For example, the first touch sensor may be implemented as a capacitive type touch sensor, a resistive type touch sensor, an opto (or optical) touch sensor, a pressure sensor, or the like.

Here, the first touch sensor 110 may be implemented as any of other various suitable types of sensors which are known in the art, in addition to the types of touch sensors described above.

The first touch sensor 110 is driven corresponding to (e.g., in accordance with) driving signals T1 to Tx supplied from a control IC 130, and may output output signals R1 to Rx detecting a contact position to the control IC 130.

Here, the second touch sensor 120 may be implemented as the same type of sensor as the first touch sensor 110.

For example, the first touch sensor 110 and the second touch sensor 120 may both be implemented by capacitive type touch sensor.

In other embodiments, the second touch sensor 120 may be implemented as a sensor of a different type from the first touch sensor 110.

For example, in the case in which the first touch sensor 110 is implemented by the capacitive type touch sensor, the second touch sensor 120 may be implemented as a resistive type touch sensor, which is different from the capacitive type touch sensor.

The second touch sensor 120 is driven corresponding to (or in accordance with) driving signals T1 to Tx supplied from the control IC 130, and may output to the control IC 130 output signals S1 to Sx detecting a contact position.

The control IC 130 controls the first touch sensor 110 and the second touch sensor 120.

In addition, the control IC 130 includes a plurality of first pins P1' coupled to both the first touch sensor 110 and the second touch sensor 120, a plurality of second pins P2 coupled to the first touch sensor 110, and a plurality of third pins P3' coupled to the second touch sensor 120.

Unlike the related art, according to the first exemplary embodiment of the present invention, there is not an individual control IC controlling each of the touch sensors 110 and 120, but a single control IC 130 collectively manages both of the first and second touch sensors 110 and 120.

To this end, the first and second touch sensors 110 and 120 are both coupled to the first pins P1' so as to share the first pins P1'.

In addition, the first touch sensor 110 is also coupled to the second pins P2 and the second touch sensor 120 is also coupled to the third pins P3'.

In the touch sensing system 100 according to the first embodiment of the present invention, the control IC 130 includes a driving signal generator 150, a first sensing circuit 160, a second sensing circuit 170, and a processor 180.

The driving signal generator 150 generates the driving signals T1 to Tx driving both of the touch sensors 110 and 120 and outputs the generated driving signals T1 to Tx to the first pins P1'. To this end, the driving signal generator 150 is coupled to the first pins P1'.

Therefore, the driving signals T1 to Tx are concurrently (e.g., simultaneously) supplied to the first touch sensor 110 and the second touch sensor 120 through the first pins P1'.

Therefore, the first and second touch sensors 110 and 120 may be driven at the same time.

Also, the driving signal generator 150 as described above may sequentially supply the driving signals T1 to Tx to the touch sensors 110 and 120 through the first pins P1'.

The first sensing circuit 160 is coupled to the second pins P2, such that the output signals R1 to Rx output from the first touch sensor 110 may be received through the second pins P2.

The second sensing circuit 170 is coupled to the third pins P3', such that the output signals S1 to Sx output from the second touch sensor 120 may be received through the third pins P3'.

The processor 180 may detect a contact position in each of the touch sensors 110 and 120 using the output signals R1 to Rx received in the first sensing circuit 160 and the output signals S1 to Sx received in the second sensing circuit 170.

As a result, the first touch sensor 110 and the second touch sensor 120 share the first pins P1' with each other, such that pins for transmitting a second set of driving signals (see, e.g., the third pins P3 as shown in FIG. 1 and present in the touch sensing system 10 according to the related art) do not need to be provided. Therefore, the entire number of pins of the control IC 130 may be decreased as compared with the related art.

In addition, the number of driving signal generators and processors may be reduced as compared with the touch sensing system 10 according to the related art.

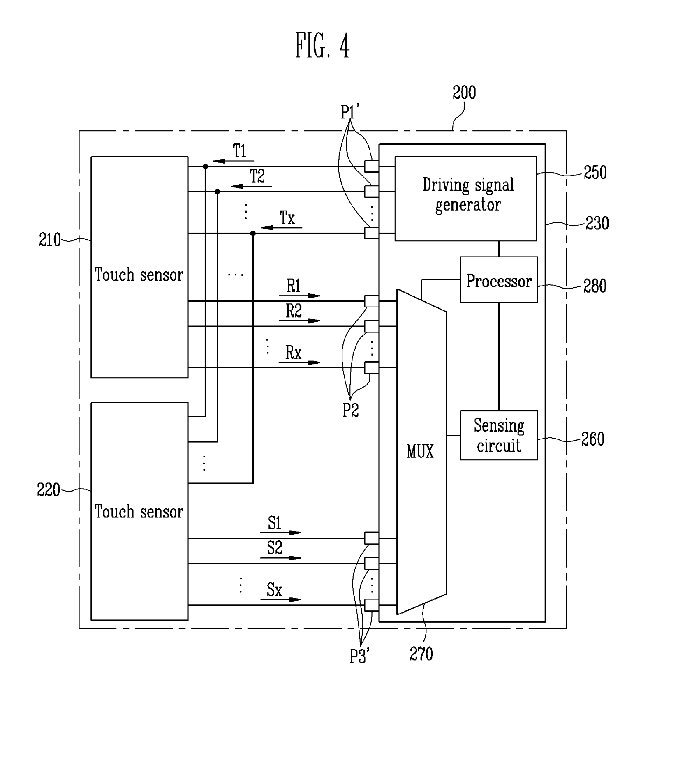

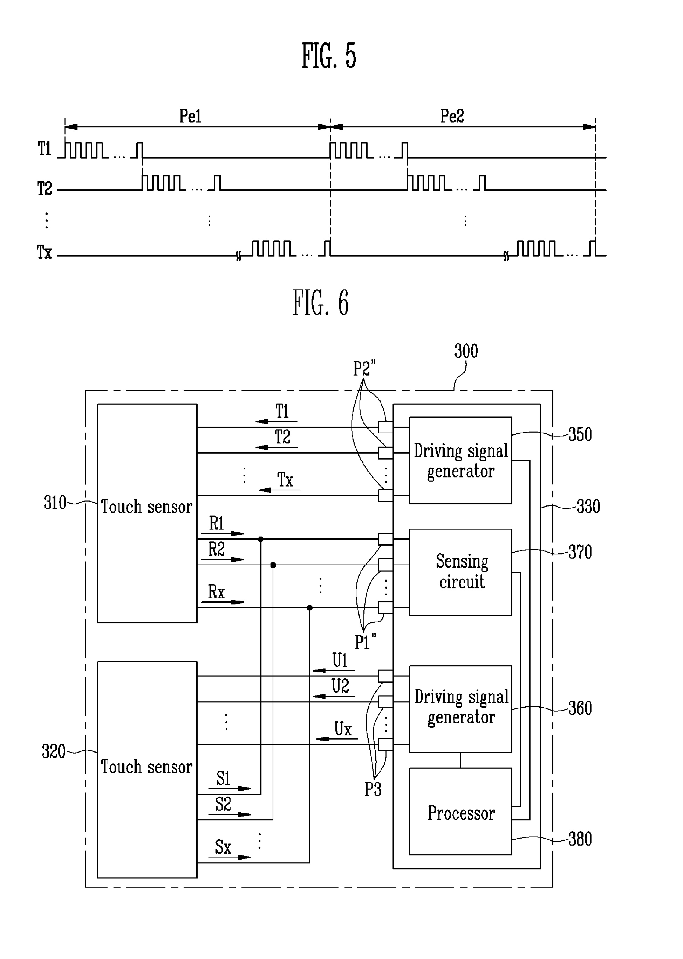

FIG. 4 is a schematic block diagram of a touch sensing system according to a second embodiment of the present invention and FIG. 5 is a waveform diagram of an operation of a driving signal generator according to the embodiment shown in FIG. 4.

Referring to FIG. 4, the touch sensing system 200 according to the second embodiment of the present invention includes a first touch sensor 210, a second touch sensor 220, and a control IC 230.

The first touch sensor 210 may detect a contact or an approach state of an object to receive a command from the outside.

Here, the first touch sensor 210 may be implemented as any of various types of sensors. For example, the first touch sensor may be implemented as a capacitive type touch sensor, a resistive type touch sensor, an opto (or optical) touch sensor, a pressure sensor, or the like.

Here, the first touch sensor 110 may be implemented as any of other various types of sensors which are known in the art, in addition to the types of touch sensors described above.

The first touch sensor 210 is driven corresponding to (e.g., in accordance with) driving signals T1 to Tx supplied from a control IC 230, and may output output signals R1 to Rx detecting a contact position to the control IC 230.

Here, the second touch sensor 220 may be implemented as the same type of sensor as the first touch sensor 210.

For example, the first touch sensor 210 and the second touch sensor 220 may both be implemented by capacitive type touch sensor.

In other embodiments, the second touch sensor 220 may be implemented as a sensor of a different type from the first touch sensor 210.

For example, in the case in which the first touch sensor 210 is implemented by the capacitive type touch sensor, the second touch sensor 220 may be implemented as a resistive type touch sensor, which is different from the capacitive type touch sensor.

The second touch sensor 220 is driven corresponding to (or in accordance with) driving signals T1 to Tx supplied from the control IC 230, and may output to the control IC 230 output signals S1 to Sx detecting a contact position.

The control IC 230 controls the first touch sensor 210 and the second touch sensor 220.

In addition, the control IC 230 includes a plurality of first pins P1' coupled to both the first touch sensor 210 and the second touch sensor 220, a plurality of the second pins P2 coupled to the first touch sensor 210, and a plurality of the third pins P3' coupled to the second touch sensor 220.

Unlike the related art, according to the second exemplary embodiment of the present invention there is not an individual control IC controlling each of the touch sensors 210 and 220, but a single control IC 230 collectively manages each (or both) of the first and second touch sensors 210 and 220.

To this end, the first and second touch sensors 210 and 220 are coupled to the first pins P1' at the same time, so as to share the first pins P1'.

In addition, the first touch sensor 210 is also coupled to the second pins P2 and the second touch sensor 220 is also coupled to the third pins P3'.

In the touch sensing system 200 according to the second embodiment of the present invention, the control IC 230 includes a driving signal generator 250, a sensing circuit 260, a multiplexer (MUX) 270, and a processor 280.

The driving signal generator 250 generates the driving signals T1 to Tx driving each (or both) of the touch sensors 210 and 220, and outputs the generated driving signals T1 to Tx to the first pins P1'. To this end, the driving signal generator 250 is coupled to the first pins P1'.

Therefore, the driving signals T1 to Tx are concurrently (e.g., simultaneously) supplied to the first touch sensor 210 and the second touch sensor 220 through the first pins P1'.

Therefore, the first and second touch sensors 210 and 220 may be driven at the same time.

Also, the driving signal generator 250 as shown in FIG 5, during each of periods Pe1 and Pe2, may sequentially supply the driving signals T1 to Tx to the touch sensors 210 and 220 through the first pins P1'.

The MUX 270 is coupled to the second and third pins P2 and P3', thereby making possible to receive signals input through the second and third pins P2 and P3'.

In addition, the MUX 270 may selectively transfer the output signals R1 to Rx of the first touch sensor 210 input through the second pins P2 and the output signals S1 to Sx of the second touch sensor 220 input through the third pins P3' to the sensing circuit 260.

For example according to one embodiment of the present invention, during the first period Pe1, the sensing circuit 260 receives the output signals R1 to Rx transferred through the second pins P2 and during the second period Pe2, the sensing circuit 260 may receive the output signals S1 to Sx transferred through the third pins P3'.

The sensing circuit 260 is coupled to the MUX 270, thereby making it possible to receive signals output from the MUX 270.

The processor 280 may detect positions of each of the touch sensors 210 and 220 using the output signals R1 to Rx and S1 to Sx received in the sensing circuit 260. For example, during the first period Pe1, because the output signals R1 to Rx of the first touch sensor 210 are transferred to the sensing circuit 260, the contact position of the first touch sensor 210 may be detected, and during the second period Pe2, because the output signals S1 to Sx of the second touch sensor 220 are transferred to the sensing circuit 260, the contact position of the second touch sensor 220 may be detected.

As a result, the first touch sensor 210 and the second touch sensor 220 share the first pins P1' with each other, such that pins for transmitting a second set of driving signals (e.g., the third pins P3 as shown in FIG. 1 and present in the touch sensing system 10 according to the related art) do not need to be provided. Therefore, the entire number of pins of the control IC 230 may be decreased as compared with the related art.

In addition, the number of driving signal generators, sensing circuits, and processors may be reduced as compared with the touch sensing system 10 according to the related art.

Also, a number of processors may be reduced through a time division multiplexing scheme using the MUX 270, as compared with the first embodiment of the present invention.

FIG. 6 is a schematic block diagram of a touch sensing system according to a third embodiment of the present invention.

Referring to FIG. 6, the touch sensing system 300 according to the third embodiment of the present invention includes a first touch sensor 310, a second touch sensor 320, and a control IC 330.

The first touch sensor 310 may detect a contact or an approach state of an object to receive a command from the outside.

Here, the first touch sensor 310 may be implemented as any of various types of sensors. For example, the first touch sensor may be implemented as a capacitive type touch sensor, a resistive type touch sensor, an opto (or optical) touch sensor, a pressure sensor, or the like.

Here, the first touch sensor 310 may be implemented as any of other various types of sensors which are known in the art, in addition to the types of touch sensors described above.

The first touch sensor 310 is driven corresponding to (e.g., in accordance with) driving signals T1 to Tx supplied from a control IC 330, and may output output signals R1 to Rx detecting a contact position to the control IC 330.

Here, the second touch sensor 320 may be implemented as the same type of sensor as the first touch sensor 310.

For example, the first touch sensor 310 and the second touch sensor 320 may both be implemented by capacitive type touch sensor.

In other embodiments, the second touch sensor 320 may be implemented as a sensor of a different type from the first touch sensor 310.

For example, in the case in which the first touch sensor 310 is implemented by the capacitive type touch sensor, the second touch sensor 320 may be implemented as a resistive type touch sensor, which is different from the capacitive type touch sensor.

The second touch sensor 320 is driven corresponding to (or in accordance with) driving signals U1 to Ux supplied from a control IC 330, and may output output signals S1 to Sx detecting a contact position to the control IC 330.

The control IC 330 performs controlling of the first touch sensor 310 and the second touch sensor 320.

In addition, the control IC 330 includes a plurality of the first pins P1" coupled to the first touch sensor 310 and the second touch sensor 320, a plurality of the second pins P2" coupled to the first touch sensor 310, and a plurality of the third pins P3 coupled to the second touch sensor 320.

Unlike the related art, the control IC 330 according to the third exemplary embodiment of the present invention there is not an individual control IC 330 controlling each of the touch sensors 310 and 320, but a single control IC 330 collectively manages each (or both) of the first and second touch sensors 310 and 320.

To this end, the first and second touch sensors 310 and 320 are both coupled to the first pins P1", so as to share the first pins P1".

In addition, the first touch sensor 310 is also coupled to the second pins P2" and the second touch sensor 320 is also coupled to the third pins P3.

In the touch sensing system 300 according to the third embodiment of the present invention, the control IC 330 includes a first driving signal generator 350, a second driving signal generator 360, a second sensing circuit 370, and a processor 380.

The driving signal generator 350 generates the driving signals T1 to Tx driving the first touch sensor 310 and outputs the generated driving signal T1 to Tx to the second pins P2". To this end, the first driving signal generator 350 may be coupled to the second pins P2".

To this end, the driving signals T1 to Tx output from the first driving signal generator 350 may be supplied to the first touch sensor 310.

The second driving signal generator 360 generates the driving signals U1 to Ux driving the second touch sensor 320 and outputs the generated driving signal U1 to Ux to the third pins P3. To this end, the second driving signals generator 360 may be coupled to the third pins P3.

To this end, the driving signals U1 to Ux output from the second driving signal generator 360 may be supplied to the second touch sensor 320.

Here, the control IC 330 includes the first diving signal generator 350 and the second diving signal generator 360, thereby making it possible to separately or concurrently (e.g., simultaneously) drive the first touch sensor 310 and the second touch sensor 320.

The sensing circuit 370 is coupled to the first pins P1", thereby making it possible to receive the signal input to the first pins P1".

That is, the sensing circuit 370 may receive the output signals R1 to Rx of the first touch sensor 310 input through the first pins P1" and the output signals S1 to Sx of the second touch sensor 320 input through the first pins P1".

The processor 380 may detect positions of each of the touch sensors 310 and 320 using the output signals R1 to Rx and S1 to Sx received in the sensing circuit 370.

For example, in the case in which operation of the second driving signal generator 360 is stopped and only the first driving signal generator 350 is driven, only the first touch sensor 310 is driven, such that only the output signals R1 to Rx of the first touch sensor 310 are input to the sensing circuit 370 through the first pins P1".

In this case, the processor 380 may detect the contact position of the first touch sensor 310 using the output signals R1 to Rx of the first touch sensor 310 received in the sensing circuit 370.

For example, in the case in which operation of the first driving signal generator 350 is stopped and only the second driving signal generator 360 is driven, only the second touch sensor 320 is driven, such that only the output signals S1 to Sx of the second touch sensor 320 are input to the sensing circuit 370 through the first pins P1".

In this case, the processor 380 may detect the contact position of the second touch sensor 320 using the output signals S1 to Sx of the second touch sensor 320 received in the sensing circuit 370.

In the case in which both the first driving signal generator 350 and the second driving signal generator 360 are driven together, both of the first touch sensor 310 and the second touch sensor 320 may be driven

Therefore, the output signals R1 to Rx of the first touch sensor 310 and the output signal S1 to Sx of the second touch sensor 320 may be input to the sensing circuit 370 through the first pins P1" at the same time.

In this case, in order to reduce interference between the output signals R1 to Rx of first touch sensor 310 and the output signals S1 to Sx of the second touch sensor 320, the driving signal T1 to Tx of the first driving signal generator 350 and the driving signal U1 to Ux of the second driving signal generator 360 may be orthogonal to one another.

In order to secure the orthogonality, a Walsh code, frequency modulation, or the like, may be used.

Therefore, according to one embodiment of the present invention, the sensing circuit 370 includes an analog filter or a digital filter, such that the output signals R1 to Rx of the first touch sensor 310 and the output signals S1 to Sx of the second touch sensor 320 may be easily separated.

As a result, the first touch sensor 310 and the second touch sensor 320 share the first pins P1" with each other, such that additional pins for receiving output signals (e.g., the fourth pins P4 as shown in FIG. 1 and present in the touch sensing system 10 according to the related art) do not need to be provided. Therefore, the entire number of pins of the control IC 330 may be decreased as compared with the related art.

In addition, the number of driving signal generators and processors may be reduced as compared with the touch sensing system 10 according to the related art.

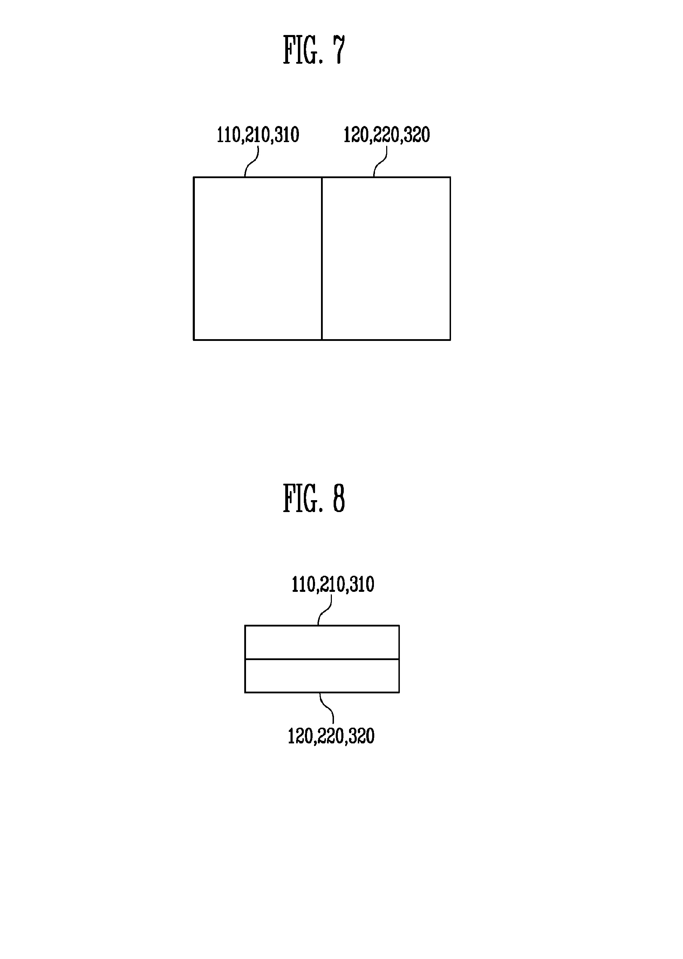

FIGS. 7 and 8 are views showing arrangements of the first touch sensor and the second touch sensor according to embodiments of the present invention.

As shown in FIG. 7, the first touch sensors 110, 210, and 310 and the second touch sensors 120, 220, and 320 according to exemplary embodiments of the present invention may be disposed in a horizontal direction.

In addition, the first touch sensors 110, 210, and 310 and the second touch sensors 120, 220, and 320 according to exemplary embodiments of the present invention may be disposed in a vertical direction as shown in FIG. 8.

With the touch sensing system according to exemplary embodiments of the present invention, it is possible to provide a touch sensing system having a reduced cost, a smaller circuit area, and a reduced number of pins by allowing a plurality of touch sensors to share one control IC with each other.

While the present invention has been described in connection with certain exemplary embodiments, it is to be understood that the invention is not limited to the disclosed embodiments, but, on the contrary, is intended to cover various modifications and equivalent arrangements included within the scope of the appended claims, and equivalents thereof.

## Claims

1. A touch sensing system (100, 200, 300) comprising:
a first touch sensor (110, 210, 310);
a second touch sensor (120, 220, 320); and
a control integrated circuit (IC) (130, 230, 330) configured to control the first touch sensor (110, 210, 310)and the second touch sensor (110, 210, 310).

2. The touch sensing system (100, 200, 300) according to claim 1, wherein the control IC (130, 230, 330) comprises:
a plurality of first pins (P1', P1") coupled to both the first touch sensor and the second touch sensor (110, 210, 310);
a plurality of second pins (P2, P2") coupled to the first touch sensor (110, 210, 310); and
a plurality of third pins (P3, P3') coupled to the second touch sensor (120, 220, 320).

3. The touch sensing system (100, 200) according to claim 2, wherein the control IC (130, 230, 330) further comprises a driving signal generator (150, 250) configured to output a driving signal (T1, T2, ...,Tx) to the first pins (P1').

4. The touch sensing system (100) according to claim 3, wherein the control IC (130) further comprises:
a first sensing circuit (160) configured to receive a first plurality of output signals (R1, R2, ..., Rx) of the first touch sensor (110) through the second pins (P2); and
a second sensing circuit (70) configured to receive a second plurality of output signals (S1, S2, ..., Sx) of the second touch sensor (120) through the third pins (P3').

5. The touch sensing system (100) according to claim 4, wherein the control IC (130) further comprises a processor (180) configured to determine a first touch position of the first touch sensor (110) using the first output signals (R1, R2, ..., Rx) received by the first sensing circuit (160) and configured to determine a second touch position of the second touch sensor (120) using the second output signals (S1, S2, ..., Sx) received by the second sensing circuit (170).

6. The touch sensing system (200) according to claim 3, wherein the control IC (230) further comprises:
a multiplexer (MUX) (270) coupled to both the second pins (P2) and the third pins (P3'); and
a sensing circuit (260) coupled to the MUX (270).

7. The touch sensing system (200) according to claim 6, wherein the MUX (270) is configured to selectively transfer the first output signals (R1, R2, ..., Rx) of the first touch sensor (210) received through the second pins (P2) and the second output signals (S1, S2, ..., Sx) of the second touch sensor (220) received through the third pins (P3') to the sensing circuit (260).

8. The touch sensing system (200) according to claim 7, wherein the MUX (270) is configured to transfer the first output signals (R1, R2, ..., Rx) of the first touch sensor (210) received through the second pins (P2) to the sensing circuit (260) during a first period (Pe1) and to transfer the second output signals (S1, S2, ..., Sx) of the second touch sensor (220) received through the third pins (P3) to the sensing circuit (26=) during a second period (Pe2).

9. The touch sensing system (200) according to claim 8, wherein the control IC (230) further comprises a processor (280) configured to determine a first touch position of the first touch sensor (210) using the first output signals (R1, R2, ..., Rx) of the first touch sensor (210) transferred to the sensing circuit (260) during the first period (Pe1) and configured to determine a second touch position of the second touch sensor (220) using the second output signals (S1, S2, ..., Sx) of the second touch sensor (220) transferred to the sensing circuit (260) during the second period (Pe2).

10. The touch sensing system (200) according to one of claims 3 to 10, wherein the first touch sensor (210) is configured to receive the driving signals (T1, T2, ..., Tx) output from the first pins (P1') and is configured to output the first output signals (R1, R2, ..., Rx) to the second pins (P2), and
wherein the second touch sensor (220) is configured to receive the driving signals (T1, T2, ..., Tx) output from the first pins (P1) and is configured to output the second output signals (S1, S2, ..., Sx) to the third pins.

11. The touch sensing system (300) according to claim 2, wherein the control IC (330) comprises a first driving signal generator (350) configured to output a first plurality of driving signals (T1, T2, ..., Tx) to the second pins (P2") and a second driving signal generator (360) configured to output a second plurality of driving signals (U1, U2, ..., Ux) to the third pins (P3).

12. The touch sensing system (300) according to claim 11, wherein the control IC (330) further comprises a sensing circuit (370) configured to receive a first plurality of output signals (R1, R2, ..., Rx) of the first touch sensor (310) and a second plurality of output signals (S1, S2, ..., Sx) of the second touch sensor (320) received through the first pins (P1").

13. The touch sensing system (300) according to claim 12, wherein the control IC (330) further comprises a processor (380) configured to determine a plurality of touch positions in the first touch sensor (310) and the second touch sensor (320) using the first output signals (R1, R2, ..., Rx) and the second output signals (S1, S2, ..., Sx) transferred to the sensing circuit (370).

14. The touch sensing system (300) according to claim 12 or 13, wherein the first touch sensor (310) is configured to receive the first driving signals (T1, T2, ..., Tx) from the second pins (P2") and is configured to output the first output signals (R1, R2, ..., Rx) to the first pins (P1"), and
the second touch sensor (320) is configured to receive the second driving signals (U1, U2, ..., Ux) from the third pins (P3) and is configured to output the second output signals (S1, S2, ..., Sx) to the first pins (P1").

15. The touch sensing system (300) according to one of claims 11 or 14, wherein the driving signal (T1, T2, ..., Tx) of the first driving signal generator (350) and the driving signal (U1, U2, ..., Ux) of the second driving signal generator (360) are orthogonal to one another and wherein the sensing circuit (370) includes a filter for separating the output signals (R1, R2, , Rx) of the first touch sensor (310) from the output signals (S1, S2,, Sx) of the second touch sensor (320).
